# EUROPEAN PATENT APPLICATION

(11) **EP 4 471 837 A1**
(43) Date of publication of application: **04.12.2024**
(21) Application number: 23909911.2
(22) Date of filing: 30.11.2023
(51) Int. Cl.: H01L 21/67, B08B 5/00

(54) **LOAD LOCK CHAMBER AND CLEANING METHOD THEREFOR, AND SEMICONDUCTOR DEVICE**

(30) Priority: 30.12.2022 CN 202211730410
(71) Applicant: Jiangsu Leadmicro Nano-Technology Co., Ltd., Wuxi, Jiangsu 214028 (CN)
(72) Inventor: ZHOU, Ren, Wuxi, Jiangsu 214028 (CN); SHI, Shuai, Wuxi, Jiangsu 214028 (CN); WU, Liuxing, Wuxi, Jiangsu 214028 (CN)
(74) Representative: Michalski Hüttermann & Partner Patentanwälte mbB
(86) International application number: PCT/CN2023/135344
(87) International publication number: WO 2024/139981

(57) **Abstract**

The present application relates to a load lock chamber and a cleaning method therefor, and a semiconductor device. The load lock chamber comprises a chamber body. The chamber body is internally provided with at least one load-lock, and is provided with an air inlet portion and an air outlet portion which are communicated with each load-lock, The chamber body is provided with at least one dispersion portion, each dispersion portion is arranged to correspond to one load-lock, each dispersion portion comprises a plurality of independently formed dispersion holes, and each dispersion hole is communicated with the air inlet portion and the corresponding load-lock and is used for dispersing airflow entering the corresponding load-lock.

## Description

### CROSS-REFERENCE TO RELATED APPLICATIONS

This application claims priority to Chinese patent application No. 2022117304102, filed on December 30, 2022, the content of which is hereby incorporated by reference in its entirety for all purposes.

### TECHNICAL FIELD

The present disclosure relates to the field of semiconductor technology, and in particular to a load lock chamber and a cleaning method therefor, and a semiconductor equipment.

### BACKGROUND

Semiconductor equipment for processing substrate (such as wafer) generally includes equipment front-end module (EFEM), load lock chamber, transfer chamber, process module and the like. During the processing of substrates, the substrates need to be placed in the load lock chamber through the EFEM under atmospheric pressure environment, and placed in the process module through the transfer chamber under vacuum environment.

Under actual production conditions, due to the pressure difference between the process module, the transfer chamber, the load lock chamber and the equipment front-end module, a large number of chemical reaction residual particles and atmospheric dust particles will inevitably enter the load lock chamber, which will contaminate the inner wall thereof and the substrate therein, affecting the substrate yield.

Generally, manufacturers will formulate corresponding product maintenance cycles according to the use of device, and regularly disassemble and clean the load lock chamber. In this cleaning method, disassembling and cleaning the load lock chamber, not only consumes a lot of time to disassemble and assemble, wasting time and energy, but also has the risk of substrate contamination during the maintenance cycle, not contributing to improving the substrate yield.

### SUMMARY

According to various embodiments of the present disclosure, a load lock chamber and a method for cleaning the same, and a semiconductor equipment are provided.

A load lock chamber includes:
a chamber body formed with at least one loading cavity therein, and having an air inlet portion and an air outlet portion that are in communication with each loading cavity;
wherein the chamber body has at least one dispersion portion, each dispersion portion is arranged corresponding to one loading cavity, each dispersion portion comprises a plurality of dispersion holes arranged independently, each dispersion hole is in communication with the air inlet portion and a corresponding loading cavity, and is configured to disperse gas flow entering the corresponding loading cavity.

In one of the embodiments, the load lock chamber is configured to load a substrate; in a height direction of the chamber body, the at least one dispersion portion is located above the substrate in the corresponding loading cavity, and outlets of the dispersion holes of the at least one dispersion portion are provided facing a side where the substrate is located.

In one of the embodiments, on a plane perpendicular to the height direction of the chamber body, an orthographic projection of the at least one dispersion portion covers an orthographic projection of the substrate in the corresponding loading cavity.

In one of the embodiments, the dispersion portion corresponding to at least one loading cavity is configured with at least two layers;
the at least two layers of the dispersion portion are arranged at intervals along a gas flow path, and projections of the dispersion holes of the at least two layers of the dispersion portion are staggered with each other on a plane perpendicular to a direction of the intervals.

In one of the embodiments, the chamber body is formed with a return air cavity and return air holes therein, the return air cavity is in communication with the air outlet portion, each loading cavity is correspondingly provided with a plurality of the return air holes, and the return air holes of the same loading cavity are independently arranged and are in communication with the return air cavity and the loading cavity.

In one of the embodiments, the dispersion portion and the return air holes that are corresponding to each loading cavity are arranged on opposite sides of the loading cavity.

In one of the embodiments, the chamber body comprises an upper cover and a side plate, the upper cover is covered on the side plate, the two cooperatively define the at least one loading cavity, the upper cover is provided with the air inlet portion, and the at least one dispersion portion is provided on the upper cover.

In one of the embodiments, the chamber body has an air inlet cavity therein in communication with the air inlet portion, the at least one dispersion portion separates the air inlet cavity from the corresponding loading cavity, and the dispersion holes of the at least one dispersion portion are in communication with the air inlet cavity and the loading cavity.

In one of the embodiments, the chamber body includes at least one partition portion that divides an internal space of the chamber body into a plurality of loading cavities independent from each other;

the at least one partition portion is formed with the air inlet cavity and the dispersion portion which are in communication with the at least one loading cavity which is separated by the partition portion.

In one of the embodiments, the plurality of loading cavities are arranged in sequence along the height direction of the chamber body, and the air inlet portion in communication with the air inlet cavity is located on a side of the chamber body.

In one of the embodiments, each of the at least one loading cavity is in communication with one air inlet portion and one air outlet portion.

In one of the embodiments, a uniform air space is formed between the at least one dispersion portion and the upper cover, and gas entering from the air inlet portion flows and diffuses in the uniform air space.

In one of the embodiments, a plurality of loading cavities are provided, the plurality of loading cavities are independent from each other, and share one air inlet cavity and one air inlet portion.

In one of the embodiments, a plurality of loading cavities are provided, the plurality of loading cavities are independent from each other, and each of the plurality of loading cavities is provided with one air inlet cavity and one air inlet portion.

A semiconductor equipment, includes the load lock chamber as described above in any one of embodiments.

A method for cleaning a load lock chamber includes:
opening an air inlet portion and an air outlet portion of a chamber body of the load lock chamber; wherein the chamber body has a loading cavity and a dispersion portion, the air inlet portion and the air outlet portion are both in communication with the loading cavity, each dispersion portion is arranged corresponding to one loading cavity, each dispersion portion comprises a plurality of dispersion holes arranged independently, and each dispersion hole is in communication with the air inlet portion and a corresponding loading cavity; and
introducing a cleaning gas into the air inlet portion until a preset condition is met.

### BRIEF DESCRIPTION OF THE DRAWINGS

In order to illustrate the embodiments of the present disclosure or technical solutions in the conventional technology more clearly, the drawings used in the embodiments or technical solutions in the conventional technology will be described briefly. Apparently, the following described drawings are merely for the embodiments of the present disclosure, and other drawings can be derived by those of ordinary skill in the art without any creative effort.
FIG. 1 is a perspective view of a load lock chamber according to some embodiments of the present disclosure;
FIG. 2 is another perspective view of the load lock chamber shown in FIG. 1;
FIG. 3 is a side view of the load lock chamber shown in FIG. 1;
FIG. 4 is a cross-sectional view taken along line A-A in FIG. 3;
FIG. 5 is a cross-sectional view taken along line B-B in FIG. 3; and
FIG. 6 is a schematic view of a semiconductor equipment according to some embodiments of the present disclosure.

1000, semiconductor equipment; 100, load lock chamber; 10, chamber body; 11, upper cover; 12, side plate; Q1, loading cavity; Q2, air inlet cavity; Q3, return air cavity; I, air inlet portion; I1, first air inlet portion; I2, second air inlet portion; O, air outlet portion; O1, first air outlet portion; 02, second air outlet portion; k2, return air hole; 10a, dispersion portion; a1, first dispersion portion; a2, second dispersion portion; k1, dispersion hole; W, uniform air space; 13, base; 14, partition portion; 20, support base; X, first direction; Y, second direction; Z, third direction; 200, equipment front-end module; 300, transfer chamber; 400, process module; 500, substrate.

### DETAILED DESCRIPTION

Embodiments of the present disclosure will now be described in detail with reference to the accompanying drawings in order to make the objects, technical features, and advantages of the present disclosure more clear. In the following description, many specific details will be set forth to facilitate a full understanding of the present disclosure. However, the present disclosure can be implemented in many other embodiments different from those described herein, and those skilled in the art can make similar improvements without violating the concept of the present disclosure, and the present disclosure is not limited to the embodiments disclosed below.

In the description of the present disclosure, the orientation or position relationships indicated by the terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present disclosure and simplify the description only, rather than indicating or implying that the apparatus or element referred to must have a particular orientation or be constructed and operated in a particular orientation, and therefore are not to be interpreted as limiting the present disclosure.

In addition, the terms "first" and "second" are used for descriptive purposes only, which cannot be construed as indicating or implying a relative importance, or implicitly specifying the number of the indicated technical features. Thus, the features defined with "first" and "second" may explicitly or implicitly include at least one feature. In the description of the present disclosure, "a plurality of" means at least two, such as two or three, unless otherwise defined explicitly and specifically.

In the present disclosure, unless otherwise specified and defined explicitly, the terms "install", "connect", "join", and "fix" should be understood in a broad sense. For example, they may refer to a fixed connection, a detachable connection, or an integral connection; may refer to a mechanical connection or electrical connection; and may refer to a direct connection, an indirect connection via an intermediate medium, an internal connection between two elements, or interaction between two elements. Those of ordinary skill in the art can understand specific meanings of these terms in the present disclosure according to specific situations.

In the present disclosure, unless otherwise specified and defined explicitly, the expression a first feature being "on" or "under" a second feature may be the case that the first feature is in direct contact with the second feature, or the first feature is in indirect contact with the second feature via an intermediate medium. Furthermore, the expression the first feature being "over", "above" and "on top of" the second feature may be the case that the first feature is directly above or obliquely above the second feature, or only means that the level of the first feature is higher than that of the second feature. The expression the first feature being "below", "underneath" or "under" the second feature may be the case that the first feature is directly underneath or obliquely underneath the second feature, or only means that the level of the first feature is lower than that of the second feature.

It should be noted that when one element is referred to as "fixed to" or "arranged on" another element, it may be directly disposed on the other element or an intermediate element may exist. When one element is considered to be "connected to" another element, it may be directly connected to the other element or an intermediate element may co-exist. The terms "vertical", "horizontal", "upper", "lower", "left", "right" and similar expressions used herein are for illustrative purposes only and do not represent the only implementation.

As recited in the background, in the prior art, most of load lock chambers are cleaned by disassembling and cleaning the same, which is time-energy consuming and is not conductive to improving the yield of the substrate.

As a transit place for substrate transportation, the load lock chamber has the ability to frequently switch between the vacuum state and the atmospheric pressure state. When the equipment front-end module picks and places the substrate into the load lock chamber, the load lock chamber needs to switch to be in the atmospheric pressure state; and when the transfer chamber picks and places the substrate into the load lock chamber, the load lock chamber needs to switch to be in the vacuum state. That is, the load lock chamber has air inlet portion and air outlet portion holes that support switching between in the vacuum state and in the atmospheric pressure state.

In the related art, the air inlet portion and air outlet portion holes of the load lock chamber are mainly configured for the transformation of the air pressure environment therein, and have little effect on the cleaning of the interior thereof. After thoroughly studying the reasons, the inventors of the present disclosure have found that, in the related art, the air inlet portion and air outlet portion holes are arranged on two opposite sides of the load lock chamber, and the number of which is 1 to 2, respectively. Since the air inlet portion is directly connected to the interior of the load lock chamber, if a large amount of air is introduced into the load lock chamber, it is easy to form a vortex therein. If the vortex of gas flow flows to the air outlet portion, the gas flow is distributed and concentrated locally and thus cannot effectively contact various parts of the inner walls of the load lock chamber, limiting the effect on removing particulate dust attached to some inner walls of the load lock chamber. Therefore, it is necessary to regularly disassemble and clean the load lock chamber, resulting in the existence of the above-mentioned technical problems.

In view of the above-mentioned technical problems, the inventors of the present disclosure propose a load lock chamber, which improves the uniform distribution of the gas flow in the load lock chamber by changing the flow state of the gas flow therein, thereby improving the uniform contact effect between the gas flow and the inner walls of the load lock chamber, and thus improving the gas flow cleaning effect on the inner walls of the load lock chamber. It can effectively reduce the frequency of disassembly and cleaning of the load lock chamber, saving time and energy, and meanwhile can also improve the cleanliness of the inner walls of the load lock chamber during the maintenance period, which is conductive to improving the substrate yield.

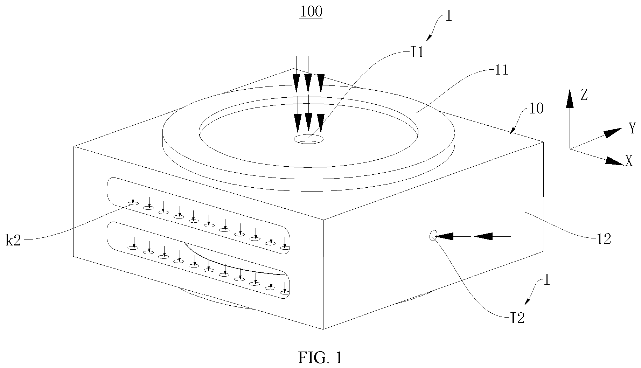

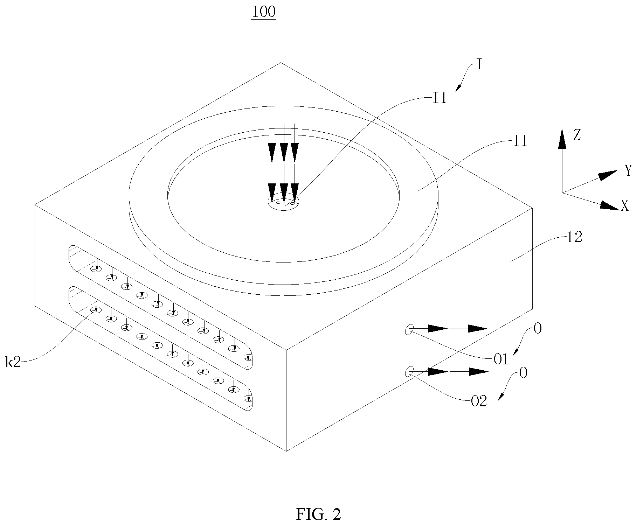

FIGS. 1 to 5 show a schematic structure of the load lock chamber according to some embodiments of the present disclosure.

Referring to FIGS. 1, 2, 3 and 4, some embodiments of the present disclosure provide a load lock chamber 100 including: a chamber body 10. The chamber body 10 is formed with at least one loading cavity Q1 therein, and the chamber body 10 has an air inlet portion I and an air outlet portion O that are in communication with each loading cavity Q1. The chamber body 10 has at least one dispersion portion 10a, and each dispersion portion 10a is arranged corresponding to one loading cavity Q1. Each dispersion portion 10a includes a plurality of dispersion holes k1 that are arranged independently. Each dispersion hole k1 is in communication with the air inlet portion I and a corresponding loading cavity Q1, and is configured to disperse gas flow entering the corresponding loading cavity Q1.

One or more loading cavities Q1 can be provided. When a plurality of loading cavities Q1 are provided, one air inlet portion I and one air outlet portion O can be provided for all loading cavities Q1. In other words, all loading cavities Q1 share one air inlet portion I and one air outlet portion O. Alternatively, one air inlet portion I and one air outlet portion O can be independently provided for each loading cavity Q1. In other words, each loading cavity Q1 is provided with one air inlet portion I and one air outlet portion O, and the plurality of air inlet portions I are independent from each other, and the plurality of air outlet portions O are independent from each other. Each air inlet portion I may include one or more air inlet portion holes, and each air outlet portion O may include one or more air outlet portion holes. The air inlet portion I is in communication with a gas supply device, and the air outlet portion O in communication with a gas extraction device. The gas supply device can provide nitrogen, inert gas, etc. The gas extraction device may include a vacuum pump. In practical application, in order to reduce the number of the gas supply device and the gas extraction device, each air inlet portion I and each air outlet portion O respectively include one air inlet portion hole and one air outlet portion hole.

As a part of the chamber body 10, the dispersion portion 10a can be integrally formed with the chamber body 10 or fixed on the chamber body 10. As for the fixing method, it can be a conventional arrangement in the art (such as fastening connection, welding, etc.), and will not be elaborated herein.

Each loading cavity Q1 is correspondingly provided with a dispersion portion 10a configured to disperse a gas flow into the loading cavity Q1. Specifically, the dispersion portion 10a includes a plurality of dispersion holes k1. Each dispersion hole k1 is independently arranged, that is, during the flowing of the gas, the gas can pass through each dispersion hole k1 of the same dispersion portion 10a at the same time and then enter the same loading cavity Q1. The cross-sectional shape of each dispersion hole k1 can be circular, square, polygonal or other shapes, which is not limited herein.

For each loading cavity Q1, after entering the air inlet portion I, the gas flow passes through the corresponding dispersion portion 10a, and is dispersed into multiple small gas flows by each of dispersion holes k1 of the dispersion portion 10a. During the dispersion process, the kinetic energy of the gas flow is lost, and the speed of the gas flow is reduced, and finally the gas flow enters the loading cavity Q1 evenly.

Compared with the prior art, through each of dispersion holes k1 of each dispersion portion 10a of each loading cavity Q1, the gas flow can be dispersed and the speed of the gas flow can be reduced, thereby effectively avoiding vortices formed by the concentration of the gas flow, making the gas distribution in the loading cavity Q1 more uniform. In this way, the contact probability between the gas flow and the inner walls of the loading cavity Q1 is greatly increased, which improves the effect of the gas flow on removing the particle dust attached to the inner walls of the loading cavity Q1, and can extend the maintenance period of the loading cavity 100, reduce the maintenance cost, and may be conducive to increasing the yield of a substrate 500. The arrangement of the dispersion portion 10a can also reduce the physical weight of the load lock chamber 100, which helps to reduce the weight of the entire chamber, and be more conducive to manual handling and assembly.

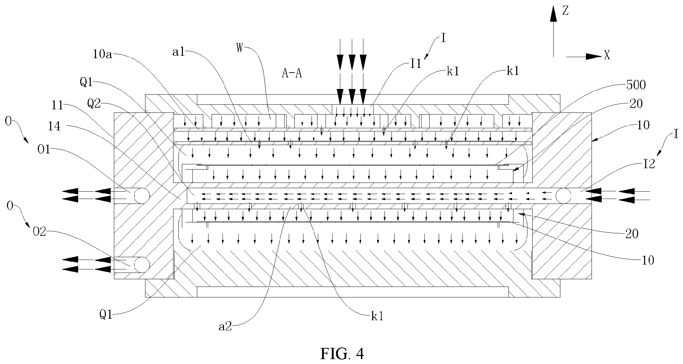

In some embodiments, referring to FIG. 4, the load lock chamber 100 is configured to load the substrate 500. In a height direction of the chamber body 10, the at least one dispersion portion 10a is located above the substrate 500 in the corresponding loading cavity Q1, and outlets of the dispersion holes k1 of the at least one dispersion portion 10a are provided towards a side where the substrate 500 is located.

Each loading cavity Q1 may be provided with one support base 20. The support base 20 is configured to support the substrate 500 loaded in the loading cavity Q1. The structure of the support base 20 is not limited, for example, it is composed of a plurality of support columns provided in the loading cavity Q1.

When the loading cavity 100 is in use, the height direction of the chamber body 10 is parallel to the gravity direction. When the substrate 500 is supported on the support base 20, the substrate 500 is located between the dispersion portion 10a and the support base 20 in the height direction.

In the embodiments shown in FIGS. 1, 2 and 3, the load lock chamber 100 is substantially in a cuboid structure, the first direction X is the width direction of the load lock chamber 100, the second direction Y is the length direction of the load lock chamber 100, and the third direction Z is the height direction of the load lock chamber 100.

The outlets of the dispersion holes k1 is provided towards the side where the substrate 500 is located, indicating that the gas flowing out of the outlets of the dispersion holes k1 flows towards the side where the substrate 500 is located. Since the velocity of the gas flow is relatively low at this time, when the gas flow passes through the substrate 500 below the dispersion portion 10a, the microparticles and dust falling on the substrate 500 can be carried away, thereby improving the cleanliness of the substrate 500, reducing the probability of the substrate 500 being corroded by microparticles and dust, and thus improving the yield of the substrate 500.

In addition, the dispersion portion 10a is arranged above the substrate 500 in the load lock chamber 100, and can be opposite to the substrate 500 on the support base 20, so that the gas flow dispersed by the dispersion portion 10a can effectively cover most of the substrate 500, making the cleaning effect on the substrate 500 better.

In other embodiments, each dispersion portion 10a can also be arranged at other positions of each loading cavity Q1, for example, the dispersion portion 10a is arranged on the inner wall of the loading cavity Q1 in the width direction or the length direction. It should be understood that since the dispersion portion 10a has the plurality of dispersion holes k1, and the dispersion holes k1 can disperse and decelerate the gas flow blown out from the air inlet portion I, the uniformity of distribution of the gas flow in the loading cavity Q1 can be improved regardless of where the dispersion portion 10a is arranged on the support base 20, thereby increasing the probability of the gas flow contacting the inner wall of the loading cavity Q1 and improving the cleanliness of the interior of the loading cavity Q1. In the embodiment of the present disclosure, there is no special limitation for the arrangement of the dispersion portion 10a.

In a specific embodiment, referring to FIG. 4, in the height direction of the chamber body 10, an orthographic projection of the at least one dispersion portion 10a on the XY plane covers an orthographic projection of the substrate 500 on the XY plane in the corresponding loading cavity Q1. When the dispersion portion 10a is located above the support base 20 and its orthographic projection on the substrate 500 covers the substrate 500, the dispersion portion 10a has a larger arrangement area on the plane perpendicular to the height direction (i.e., the XY plane), and can send the gas flow to most of the space of the loading cavity Q1, such that the probability of the gas flow contacting the inner wall of the loading cavity Q1 is relatively great, which helps to improve the cleaning effect on the inner wall of the loading cavity Q1.

In some embodiments, referring to FIG4, the dispersion portion 10a corresponding to a at least one loading cavity Q1 is configured with at least two layers, all dispersion portions 10a are arranged at intervals along a gas flow path, and the projections of the dispersion holes k1 of at least two dispersion portions 10a on a plane perpendicular to an interval direction are staggered with each other. As can be seen from FIG. 4, at least two dispersion portions 10a are arranged at intervals in the Z direction, and the projections of the dispersion holes k1 of adjacent two dispersion portions 10a do not overlap on the XY plane.

The gas flow path refers to a path for gas to flow from the air inlet portion I to the loading cavity Q1. When the dispersion portions 10a are arranged at intervals along the gas flow path, the gas can flow through the dispersion portions 10a in sequence.

The interval direction refers to the direction in which the dispersion portions 10a are arranged at intervals. On a plane perpendicular to the interval direction (defined as a reference plane), the dispersion holes k1 of at least two dispersion portions 10a (specifically, the first dispersion portion a1) are staggered with each other. In other words, the projections of the dispersion holes k1 of at least two dispersion portions 10a on the reference plane do not intersect with each other. Specifically, the dispersion holes k1 of two adjacent dispersion portions 10a can be staggered on the reference plane perpendicular to the interval direction, and the dispersion holes k1 of two dispersion portions 10a separated by a certain dispersion portion 10a in the interval direction are staggered on the reference plane perpendicular to the interval direction.

When the gas flow passes through the dispersion holes k1 arranged staggered of multiple layers of the dispersion portions 10a, the gas flow can be dispersed multiple times and its kinetic energy can be consumed. As a result, the gas flow flowing to the loading cavity Q1 can be more dispersed and uniform, and the flow speed is slower, such that the substrate 500 will not be damaged due to the impact of the gas flow speed being too fast, which helps to improve the yield of the substrate 500.

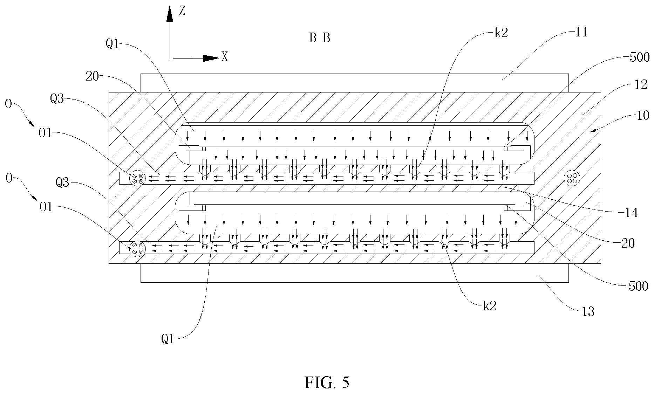

In some embodiments, referring to FIG. 5, the chamber body 10 is formed with a return air cavity Q3 and return air holes k2 therein, and the return air cavity Q3 is in communication with the air outlet portion O. Each loading cavity Q1 is correspondingly provided with a plurality of the return air holes k2, and the return air holes k2 of the same loading cavity Q1 are independently arranged and are in communication with the return air cavity Q3and the loading cavity Q1.

The return air holes k2 are arranged on the inner wall of each loading cavity Q1. Each loading cavity Q1 is provided with a plurality of return air holes k2. Each return air hole k2 is in communication with the return air cavity Q3. The gas in the loading cavity Q1 enters the return air cavity Q3 through each return air hole k2, and then is discharged outside the chamber body 10 through the return air cavity Q3 and the air outlet portion O.

One return air cavity Q3 can be arranged corresponding to one loading cavity Q1, the gas in each loading cavity Q1 enters the corresponding return air cavity Q3 through the return air hole k2 thereon, and then is discharged outside the chamber body 10 through the air outlet portion O. One return air cavity Q3 can also be arranged corresponding to a plurality of loading cavities Q1, and the gas in multiple loading cavities Q1 enters the same return air cavity Q3 through the respective return air holes k2, and then is discharged outside the chamber body 10 through the air outlet portion part O.

At this time, the gas in each loading cavity Q1 can dispersedly enter the return air cavity Q3 through each return air hole k2, and then flow to the air outlet portion O. Compared with the solution of discharging gas through one gas outlet hole in the prior art, in the present disclosure, when the gas flows out of the loading cavity Q1, it will not be concentrated in one place but dispersedly flow out from multiple positions of the loading cavity Q1, which helps to improve the uniform distribution effect of the gas flow in the loading cavity Q1, and thus further improve the cleaning effect on the inner wall of the loading cavity Q1. Furthermore, the arrangement of the return air cavity Q3 also helps to reduce the weight of the load lock chamber 100.

In a specific embodiment, the dispersion portion 10a and the return air holes k2 that are corresponding to each loading cavity Q1 are arranged on opposite sides of the loading cavity Q1. Specifically, the dispersion portion 10a and the return air hole k2 can be arranged on both sides of the loading cavity Q1 in the height direction, or can be arranged on both sides of loading cavity Q1 in the width direction (or length direction), which is not specifically limited herein.

When the dispersion portion 10a and the return air hole k2 are arranged opposite to each other, the gas flows out from each dispersion hole k1 of the dispersion portion 10a, and the gas flows along a basically straight path to each return air hole k2. The gas flow has fewer turns in the loading cavity Q1 and can pass through most areas within the space on both sides, making cleaning range large, and thus improving the cleaning effect on the loading cavity Q1.

In some embodiments, referring to FIG. 4, the chamber body 10 includes an upper cover 11 and a side plate 12. The upper cover 11 covers the side plate, and the two cooperatively define at least one loading cavity Q1. The upper cover 11 is provided with the air inlet portion I, and the dispersion portion 10a is provided on the upper cover 11.

In the height direction of the chamber body 10, the upper cover 11 covers an upper portion of the side plate 12. The upper cover 11 and the side plate 12 define at least one loading cavity Q1. When the upper cover 11 and the side plate 12 define a plurality of loading cavities Q1, the plurality of loading cavities Q1 are arranged adjacent to each other in the width direction and/or the length direction of the chamber body 10. The upper cover 11 and the side plate 12 defining the loading cavity Q1 means that the upper cover 11 and the side plate 12 form at least part of the inner wall of the loading cavity Q1.

The air inlet portion I provided on the upper cover 11 is a first air inlet portion I1, which is located above the loading cavity Q1 communicating therewith, that is, the loading cavity Q1 is supplied with gas from above, and in this case the gas has a short inlet path and a fast inlet speed.

It should be understood that a uniform air space W is formed between the dispersion portion 10a and the upper cover 11. The gas from the air inlet portion I first enters the uniform air space W, flows and diffuses in the uniform air space W, and then flows to the loading cavity Q1 through the dispersion holes k1 which are on the dispersion portion 10a and is in communication with the uniform air space W.

At this time, the gas flow entering the loading cavity Q1 through the air inlet portion I on the upper cover 11 flows from top to bottom (i.e., flows along the direction indicated by the arrow inside the chamber body 10 shown in FIG. 4), which can effectively clean the substrate 500 on the support base 20.

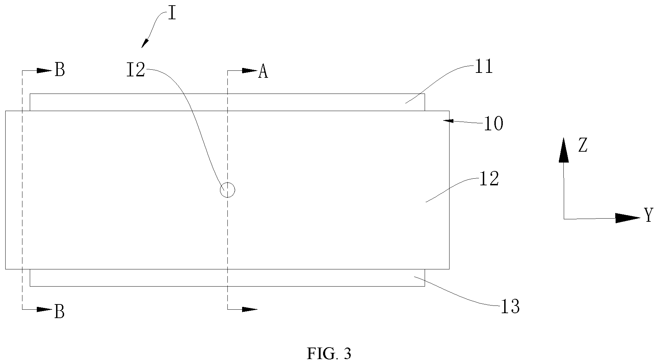

In a further embodiment, referring to FIGS. 3 and 4, the cavity body 10 further includes a base 13, which is arranged below the side plate 12. The upper cover 11, the side plate 12, and the base 13 cooperatively form an internal space of the cavity body 10. The base 13 and the side plate 12 can be integrally formed, or can be separately arranged and fixedly connected. It should be understood that the upper cover 11, the base 13 and the side plate 12 are hermetically connected.

In some embodiments, referring to FIG. 4, the chamber body 10 has an air inlet cavity Q2 in communication with the air inlet portion I. At least one dispersion portion 10a separates the air inlet cavity Q2 from the corresponding loading cavity Q1, and the dispersion holes k1 thereon are in communication with the air inlet cavity Q2 and the loading cavity Q1.

The air inlet cavity Q2 is a space formed in the chamber body 10, which is in communication with at least one air inlet portion I, and with the corresponding loading cavity Q1 through at least one dispersion portion 10a. One air inlet cavity Q2 and one air inlet portion I can be provided corresponding to one loading cavity Q1. Alternatively, one air inlet cavity Q2 and one air inlet portion I can be provided corresponding to the plurality of loading cavities Q1, that is, the plurality of loading cavities Q1 share one air inlet cavity Q2 and one air inlet portion I. The arrangements of the air inlet cavity Q2, the air inlet portion I, and the loading cavity Q1 are not limited herein.

The partition portion 14 separates the air inlet cavity Q2 from the corresponding loading cavity Q1. In this case, the partition portion 14 may be a part of the chamber body 10 and integrally formed with the chamber body 10, and the partition portion 14 and other parts of the chamber body 10 cooperatively enclose the air inlet cavity Q2.

In this case, the gas entering from the air inlet portion I first passes through the air inlet cavity Q2, and then disperses into the loading cavity Q1 through the dispersion holes k1 on the partition portion 14. The arrangement position of the air inlet portion I can be flexible.

In some embodiments, referring to FIGS. 4 and 5, the chamber body 10 includes at least one partition portion 14. All of the partition portions 14 divide an internal space of the chamber body 10 into a plurality of loading cavities Q1 independent from each other. At least one partition portion 14 is configured with the air inlet cavity Q2 and the dispersion portion 10a which are in communication with at least one loading cavity Q1 separated by the partition portion 10a.

The partition portion 14 can be integrally formed with the chamber body 10, or can be fixedly connected to the chamber body 10, as long as the loading cavities Q1 can be independent from each other. The plurality of partition portions 14 can be arranged at intervals along the height direction of the chamber body 10, or can be arranged at intervals along the width direction or length direction of the chamber body 10, which are not limited herein.

At least one the partition portion 14 has an air inlet cavity Q2 and a dispersion portion 10a (specifically, for example, a second dispersion portion a2), that is, the partition portion 14 acts as a gas flow medium to deliver gas to the loading cavity Q1 formed by itself. It should be understood that the dispersion portion 10a provided on the partition portion 14 can be integrally formed with other parts of the partition portion 14, or can be provided separately and fixedly, which is not limited herein.

In this case, the internal space of the chamber body 10 is divided into a plurality of loading cavities Q1 by the partition portion 14, which improves the transfer capability of the loading cavity 100 and helps to improve the production efficiency of the semiconductor equipment 1000 equipped with the loading cavity 100. Further, the air inlet cavity Q2 helps to reduce the overall weight of the loading cavity 100.

In further embodiments, referring to FIG. 4, all of the loading cavities Q1 are arranged in sequence along the height direction of the chamber body 10, and the air inlet portion I in communication with the air inlet cavity Q2 is located on a side of the chamber body 10.

The loading cavities Q1 are adjacently arranged along the height direction of the chamber body 10, indicating that the partition portion 14 extends along the length direction or the width direction of the chamber body 10. When the partition portion 14 has an air inlet cavity Q2, and the air inlet portion I is located on the side of the chamber body 10, the distance between the air inlet portion I and the air inlet cavity Q2 is relatively short, which can shorten the distance for the gas to enter the air inlet cavity Q2 from the air inlet portion I, thereby accelerating the delivery of the gas to the loading cavity Q1.

In some embodiments, each loading cavity Q1 is in communication with an air inlet portion I and an air outlet portion O in a one-to-one correspondence. That is, one loading cavity Q1 is in communication with one air inlet portion I and one air outlet portion O, such that the corresponding loading cavity Q1 can perform an independent air-inlet and an independent air-outlet, so as to provide different air pressure states. In practical applications, some loading cavities Q1 can be in a vacuum state to facilitate the transfer chamber 300 to pick and place the substrate 500, and other loading cavities Q1 can be in an atmospheric pressure state to facilitate the equipment front-end module 200 to pick and place the substrate 500. In this way, both the transfer efficiency and the processing efficiency of the substrate 500 can be improved.

It should be understood that when both an air inlet cavity Q2 and an air return cavity Q3 are provided in one partition portion 14, the two cavities are independent. The air inlet cavity Q2 and the air return cavity Q3 of the same partition portion 14 can be arranged in layers up and down, or the air return cavity Q3 can be arranged around the air inlet cavity Q2, or the air inlet cavity Q2 can be arranged around the air return cavity Q3, or the air inlet cavity Q2 and the air return cavity Q3 are arranged at intervals from left to right, which is not specifically limited.

It should be noted that the chamber body 10 is configured with a first pick-place opening and a second pick-place opening that are in communication with the loading cavity Q1.The first pick-place opening is configured for the equipment front-end module 200 to pick and place the substrate 500 in the loading cavity Q1, and the second pick-place opening is configured for the transfer chamber 300 to pick and place the substrate 500 in the load lock chamber Q1. The transfer chamber 300 and the equipment front-end module 200 are providied with corresponding mechanisms for transporting the substrate 500, such as a manipulator. The specific structures of the transfer chamber 300 and the equipment front-end module 200 are not limited in the embodiments of the present disclosure, and can be configured by referring to the conventional equipment structure. When a plurality of loading cavities Q1 are provided, a first pick-place opening and a second pick-place opening are provided corresponding to each loading cavity Q1. When the equipment front-end module 200 and the transfer chamber 300 finish transporting the substrate 500, the first and second pick-place openings are closed to facilitate the formation of vacuum loading in the loading cavity Q1 and prevent impurities such as external microparticles and dust from entering the loading cavity Q1.

In order to help those skilled in the art to understand the technical concept of the present disclosure more deeply, the load lock chamber 100 will be described below according to one embodiment of the present disclosure.

In one embodiment, referring to FIGS. 4 and 5, the load lock chamber 100 includes a chamber body 10 and a support base 20. The chamber body 10 includes an upper cover 11, a side plate 12, a base 13, and a partition portion14. The upper cover 11, the side plate 12, and the base 13 are connected in sequence along the height direction of the chamber body 10 to cooperatively enclose an internal space of the chamber body 10. The partition portion 14 is disposed in the chamber body 10 and divides the internal space of the chamber body 10 into a plurality of loading cavities Q1 that are disposed in sequence in the height direction and are independent from each other, and each loading cavity Q1 is provided with the support base 20. The upper cover 11 has a first air inlet portion I1 in communication with the uppermost loading cavity Q1. The side plate 12 has a plurality of second air inlet portions I2, and each second air inlet portion I2 is in communication with the remaining loading cavities Q1 in a one-to-one correspondence except the uppermost loading cavity Q1. The air outlet portion O in communication with the uppermost loading cavity Q1 is the first air outlet portion O1, and the air outlet portion O in communication with the other loading cavities Q1 in a one-to-one correspondence is the second air outlet portion O2. The first air outlet portion O1 and the second air outlet portion O2 are both arranged on the side plate 12.

The dispersion portion 10a includes a first dispersion portion a1 and a second dispersion portion a2. The first dispersion portion a1 is arranged in the uppermost loading cavity Q1 and connected to the upper cover 11. A plurality of dispersion holes k1 are provided on the first dispersion portion a1 for dispersing and discharging the gas flow in the first air inlet portion part I1 to various places of the loading cavity Q1. The second dispersion portion a2 is formed on the partition portion 14 defining the upper inner wall of other loading cavities Q1, and the air inlet portion chamber Q2 is provided in the partition portion 14. The air inlet portion cavities Q2 of each partition portion 14 is in communication with a loading cavity Q1 and a second air inlet portion I2 through the dispersion holes k1 of the dispersion portion 10a of each partition portion 14.

Further, a plurality of return air holes k2 are formed at the bottom of each loading cavity Q1, and a return air cavity Q3 is formed on the bottom inner wall portion (such as the partition portion 14 or the bottom plate) defining each loading cavity Q1. The return air cavity Q3 is connected to each air outlet portion O in a one-to one correspondence.

In this embodiment, the gas flow entering each loading cavity Q1 from each air inlet portion I can flow from top to bottom, thus achieving a good cleaning effect on the inner wall of each loading cavity Q1 and the substrate 500. Further, the arrangement of the return air cavity Q3, the air inlet cavity Q2, and the dispersion portion 10a also helps to reduce the weight of the loading cavity 100, making the transportation and disassembly of the load lock chamber 100 more labor-saving.

Further, some embodiments of the present disclosure also provide a semiconductor equipment 1000, which includes the load lock chamber 100 as described in any one of the embodiments above and has all the beneficial effects of the above load lock chamber 100, which will not be described herein.

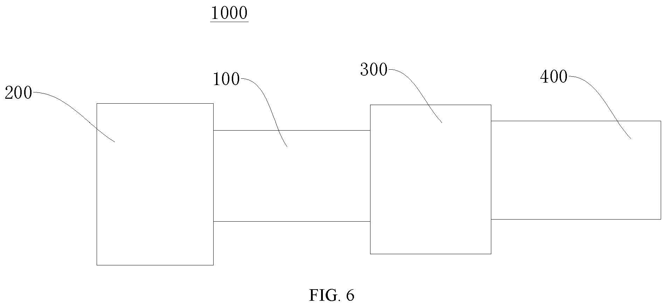

In addition, referring to FIG. 6, the semiconductor equipment 1000 may further include an equipment front-end module 200, a transfer chamber 300, and a process module 400. The load lock chamber 100 is located between the equipment front-end module 200 and the transfer chamber 300. The transfer chamber 300 is located between the process module 400 and the loading cavity 100. The process module 400 is configured to process (such as coating, etching, etc.) the substrate 500. The transfer chamber 300 is configured to transport the substrate 500 between the loading cavity 100 and the process module 400. The equipment front-end module 200 is configured to pick and place the substrate 500 from the load lock chamber 100. The specific structure of the equipment front-end module 200, the transfer chamber 300 and the process module 400 is not limited in the embodiments of the present disclosure, and can be understood by referring to the existing structure.

Moreover, some embodiments of the present disclosure also provide a method for cleaning a load lock chamber 100, including:
S10, an air inlet portion I and an air outlet portion O of a chamber body 100 of the load lock chamber 100 are opened. The chamber body 10 has a loading cavity Q1 and a dispersion portion 10a. The air inlet portion I and the air outlet portion O are both in communication with the loading cavity Q1. Each dispersion portion 10a is arranged corresponding to one loading cavity Q1, and includes a plurality of dispersion holes k1 arranged independently. Each dispersion hole k1 is in communication with the air inlet portion I and a corresponding loading cavity Q1.
S20, a cleaning gas is introduced into the air inlet portion I until a preset condition is met.

The structure of the load lock chamber100 can refer to the structure descried in the above embodiments, and will not be described herein. In step S10, when the load lock chamber 100 needs to be cleaned, the air inlet portion I and the air outlet portion O are opened. Specifically, a switch valve can be provided at the inlet of the air inlet portion I and the outlet of the air outlet portion O, respectively, and the air inlet portion and the air outlet portion are opened and closed by controlling the switch of the switch valve. Alternatively, an air inlet portion pump is provided at the air inlet portion I, and an air extraction pump is provided at the air outlet portion O, and the air inlet portion I is opened by starting the air inlet portion pump, and the air outlet portion O is opened by starting the air extraction pump.

In step S20, through the air inlet portion pump the air inlet portion I can are in communication with the air storage tank storing cleaning gas, such as nitrogen, inert gas. When it is necessary to introduce the cleaning gas into the air inlet portion I, the air inlet portion pump is turned on, and under the conveyance of the air inlet portion pump, the cleaning gas continuously enters the dispersion portion from the air storage tank through the air inlet portion, and then enters the loading cavity Q1 under the dispersion of the dispersion portion, and finally flows out of the loading cavity Q1 through the air outlet portion O.

The preset condition may be that the time for introducing the cleaning gas reaches a set value, and when the set cleaning time is reached, the cleaning is assumed to be in place. Of course, a gas sampling device may also be provided on the air outlet portion O, through which whether the cleanliness of the gas flowing out of the gas outlet reaches a preset condition can be detected, so as to determine whether the cleaning is in place.

Specifically, step S10 can be performed before or after the equipment front-end module 200 places the substrate 500 in the loading cavity Q1, or it can be performed after the equipment front-end module 200 takes out the substrate 500 from the loading cavity Q1, and there is no special limitation. Step S10 can be performed as long as there is a cleaning requirement.

The load lock chamber, the cleaning method thereof, and the semiconductor equipment according to the present disclosure can effectively solve the problem that the cleaning method of the load lock chamber in the prior art is time-energy consuming and is not conducive to improving the substrate yield.

According to the load lock chamber and the cleaning method thereof, and semiconductor equipment of the present disclosure, the gas flow can be dispersed and decelerated through the dispersion holes of each dispersion portion of each loading cavity, effectively avoiding vortices formed by the concentration of the gas flow, making the gas distribution in the loading cavity more uniform, greatly increasing the probability of the gas flow contacting the inner wall of the loading cavity, and thereby improving the effect on the gas flow removing microparticles and dust attached thereto. As a result, the maintenance period of the load lock chamber can be extended, maintenance costs can be decreased, and it can also be conducive to improving the substrate yield. Further, the arrangement of the dispersion portion can also reduce the physical weight of the load lock chamber, thereby help to reduce the weight of the entire chamber, and thus be more conducive to manual handling and assembly.

In addition, the load lock chamber and the cleaning method thereof, and the semiconductor equipment configured as described above according to the present disclosure also have a rapid cooling function.

Although the respective embodiments have been described one by one, it shall be appreciated that the respective embodiments will not be isolated. Those skilled in the art can apparently appreciate upon reading the disclosure of this application that the respective technical features involved in the respective embodiments can be combined arbitrarily between the respective embodiments as long as they have no collision with each other. Of course, the respective technical features mentioned in the same embodiment can also be combined arbitrarily as long as they have no collision with each other.

Although the invention is illustrated and described herein with reference to specific embodiments, the invention is not intended to be limited to the details shown. Rather, various modifications may be made in the details within the scope and range of equivalents of the claims and without departing from the invention.

## Claims

1. A load lock chamber, comprising:
a chamber body formed with at least one loading cavity therein, and having an air inlet portion and an air outlet portion that are in communication with each loading cavity;
wherein the chamber body has at least one dispersion portion, each dispersion portion is arranged corresponding to one loading cavity, each dispersion portion comprises a plurality of dispersion holes arranged independently, each dispersion hole is in communication with the air inlet portion and a corresponding loading cavity, and is configured to disperse gas flow entering the corresponding loading cavity.

2. The load lock chamber according to claim 1, wherein the load lock chamber is configured to load a substrate;
in a height direction of the chamber body, the at least one dispersion portion is located above the substrate in the corresponding loading cavity, and outlets of the dispersion holes of the at least one dispersion portion are provided facing a side where the substrate is located.

3. The load lock chamber according to claim 2, wherein on a plane perpendicular to the height direction of the chamber body, an orthographic projection of the at least one dispersion portion covers an orthographic projection of the substrate in the corresponding loading cavity.

4. The load lock chamber according to claim 1, wherein the dispersion portion corresponding to at least one loading cavity is configured with at least two layers;
the at least two layers of the dispersion portion are arranged at intervals along a gas flow path, and projections of the dispersion holes of the at least two layers of the dispersion portion are staggered with each other on a plane perpendicular to a direction of the intervals.

5. The load lock chamber according to any one of claims 1 to 4, wherein the chamber body is formed with a return air cavity and return air holes therein, the return air cavity is in communication with the air outlet portion, each loading cavity is correspondingly provided with a plurality of the return air holes, and the return air holes of the same loading cavity are independently arranged and are in communication with the return air cavity and the loading cavity.

6. The load lock chamber according to claim 5, wherein the dispersion portion and the return air holes that are corresponding to each loading cavity are arranged on opposite sides of the loading cavity.

7. The load lock chamber according to any one of claims 1 to 4, wherein the chamber body comprises an upper cover and a side plate, the upper cover is covered on the side plate, the two cooperatively define the at least one loading cavity, the upper cover is provided with the air inlet portion, and the at least one dispersion portion is provided on the upper cover.

8. The load lock chamber according to any one of claims 1 to 4, wherein the chamber body has an air inlet cavity therein in communication with the air inlet portion, the at least one dispersion portion separates the air inlet cavity from the corresponding loading cavity, and the dispersion holes of the at least one dispersion portion are in communication with the air inlet cavity and the loading cavity.

9. The load lock chamber according to claim 8, wherein the chamber body comprises at least one partition portion that divides an internal space of the chamber body into a plurality of loading cavities independent from each other;
the at least one partition portion is formed with the air inlet cavity and the dispersion portion which are in communication with the at least one loading cavity which is separated by the partition portion.

10. The load lock chamber according to claim 9, wherein the plurality of loading cavities are arranged in sequence along the height direction of the chamber body, and the air inlet portion in communication with the air inlet cavity is located on a side of the chamber body.

11. The load lock chamber according to any one of claims 1 to 4, wherein each of the at least one loading cavity is in communication with one air inlet portion and one air outlet portion.

12. The load lock chamber according to claim 7, wherein a uniform air space is formed between the at least one dispersion portion and the upper cover, and gas entering from the air inlet portion flows and diffuses in the uniform air space.

13. The load lock chamber according to claim 8, wherein a plurality of loading cavities are provided, the plurality of loading cavities are independent from each other, and share one air inlet cavity and one air inlet portion.

14. The load lock chamber according to claim 8, wherein a plurality of loading cavities are provided, the plurality of loading cavities are independent from each other, and each of the plurality of loading cavities is provided with one air inlet cavity and one air inlet portion.

15. A semiconductor equipment, comprising the load lock chamber according to any one of claims 1 to 14.

16. A method for cleaning a load lock chamber, comprising:
opening an air inlet portion and an air outlet portion of a chamber body of the load lock chamber; wherein the chamber body has a loading cavity and a dispersion portion, the air inlet portion and the air outlet portion are both in communication with the loading cavity, each dispersion portion is arranged corresponding to one loading cavity, each dispersion portion comprises a plurality of dispersion holes arranged independently, and each dispersion hole is in communication with the air inlet portion and a corresponding loading cavity; and introducing a cleaning gas into the air inlet portion until a preset condition is met.
